# EUROPEAN PATENT SPECIFICATION

(11) **EP 0 578 177 B1**
(45) Date of publication and mention of the grant of the patent: **05.03.1997**
(21) Application number: 93110730.4
(22) Date of filing: 05.07.1993
(51) Int. Cl.: G03F 7/038, G03F 7/004

(54) **Heat-resistant negative photoresist composition, photosensitive substrate, and process for forming negative pattern**
Hitzebeständige, negativ-arbeitende Photoresistzusammensetzung, lichtempfindliches Substrat und Verfahren zur Herstellung eines negativen Musters
Compostion pour photoréserve de type négatif, résistante à la chaleur, substrat photosensible et procédé pour préparer un motif négatif

(30) Priority: 07.07.1992 JP 179685/92; 26.10.1992 JP 287384/92
(43) Date of publication of application: 12.01.1994
(73) Proprietor: NITTO DENKO CORPORATION, Osaka (JP)
(72) Inventor: Omote, Toshihiko, Ibaraki-shi, Osaka (JP); Hayashi, Shunichi, Ibaraki-shi, Osaka (JP); Fujii, Hirofumi, Ibaraki-shi, Osaka (JP)
(74) Representative: Grünecker, Kinkeldey, Stockmair & Schwanhäusser Anwaltssozietät

(56) References cited:
- EP-A- 0 502 400
- DE-A- 4 007 236
- DE-C- 3 335 309
- FR-A- 2 197 189

## Description

The present invention relates to a heat-resistant negative photoresist composition, a photosensitive substrate, and a process for forming a negative pattern.

Photosensitive polyimides or precursors thereof which have been in common practical use because of their heat resistance are mostly of a negative-working type which becomes less soluble in developing solutions upon irradiation with actinic rays to form a desired relief image on various substrates.

Many kinds of heat-resistant photoresists and applications thereof have been proposed which photoresists employ such a negative photosensitive polyimide or precursor thereof and leave actinic ray-irradiated areas on substrates. Examples of these proposals include: (1) a method of incorporating a methacryloyl group into a polyimide precursor through an ester bond or ionic bond (e.g., JP-A-54-145794, and JP-A-56-38038); (2) soluble polyimides containing a photopolymerizable olefin (JP-A-59-108031, JP-A-59-220730, JP-A-59-232122, JP-A-60-6729, JP-A-60-72925, and JP-A-61-57620); and (3) self-sensitizing polyimides having a benzophenone skeleton and containing an alkyl group at the ortho position of an aromatic ring to which a nitrogen atom is bonded (e.g., JP-A-59-219330 and JP-A-59-231533).

However, the conventional negative photoresists described above are insufficient regarding the resolving power. Further, in some applications the use thereof leads to low yields of products. Illustratively stated, the photoresists obtained by method (1) above are disadvantageous in that the ester bond-type ones are difficult to synthesize, while the ionic bond-type ones have a problem concerning dimensional stability because they not only shrink upon heat cure for imidization but decrease in thickness during development, so that a residual film thickness thereof after development and heat cure is about 50% of the initial thickness. Photoresists (2) and (3) above are disadvantageous in that they are unable to flexibly cope with various kinds of property requirements and are not suitable for use as a multipurpose photoresist, since polymers usable therein are limited in skeletal structure and, hence, films finally obtained therefrom have limited properties.

On the other hand, a photosensitive material comprising a polyimide precursor and N-methylolacrylamide incorporated therein has been proposed *(Polymer Preprint Japan,* 39 (8), 2397 (1990)). This composition, however, is disadvantageous, for example, in that it has poor dimensional stability because the residual film thickness is 50% as in the above-described case, and in that the pre-baking thereof requires much time. EP-A-502400 which is a prior art document according to Article 54(3) for the contracting states BE,DE,FR and GB regarding those parts of the present application which are based on the priority document of July 7, 1992, discloses a heat-resistant photoresist composition comprising a resin component of formula (I) and a compound which becomes basic upon irradiation with actinic rays, which can be 2,6-dimethyl-3,5-dicyano-4-(2'-nitrophenyl)-1,4-dihydropyridine or 2,6-dimethyl-3,5-diacetyl-4-(2'-nitrophenyl)-1,4-dihydropyridine.

One object of the present invention is to provide a heat-resistant negative photoresist composition comprising a polyimide precursor and showing good sensitivity and resolving power in which composition the polyimide precursor as a resin imparting the heat resistance required of a resist material is not so limited in structure and which is adaptable to practical production processes, thereby overcoming problems of the conventional negative photoresists.

Another object of the present invention is to provide a photosensitive substrate obtained using the above heat-resistant negative photoresist composition.

Still another object of the present invention is to provide a process for forming a negative pattern.

As a result of intensive studies on the above-described negative photoresist compositions, the present inventors have found that a negative photoresist composition with which the above objects are attainable can be obtained by incorporating a specific compound which becomes basic upon irradiation with actinic rays into a resin component comprising a polyimide precursor. The present invention has been completed based on this finding.

The present invention provides a heat-resistant negative photoresist composition comprising a resin component having a structural unit represented by formula (I): 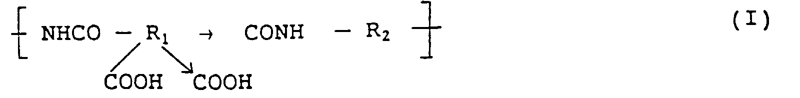 wherein the COOH groups should always take the ortho-positions or adjacent positions with respect to the -CONH- linkages, R₁ represents a tetravalent aromatic or aliphatic hydrocarbon residue, and R₂ represents a divalent aromatic or aliphatic hydrocarbon residue, and a compound which becomes basic upon irradiation with actinic rays, represented by formula (II) or formula (III): 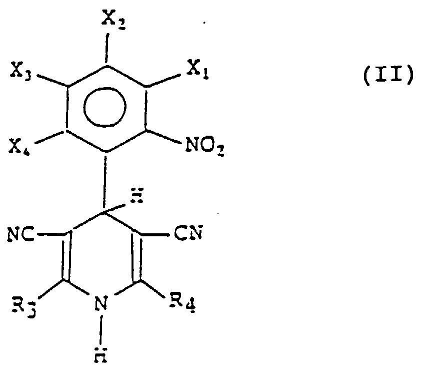 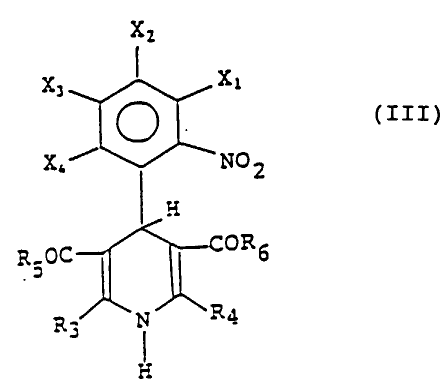 wherein R₃ and R₄ each represents a hydrogen atom or an alkyl group having 1 to 3 carbon atoms, R₅ and R₆ each is an alkyl group having 1 to 4 carbon atoms, and X₁ to X₄ each is one member selected from the group consisting of a hydrogen atom, a fluorine atom, a nitro group, a methoxy group, a dialkylamino group, an amino group, a cyano group and a fluoroalkyl group.

The present invention further provides a neat-resistant negative photoresist composition comprising a resin component having a structural unit represented by formula (I): 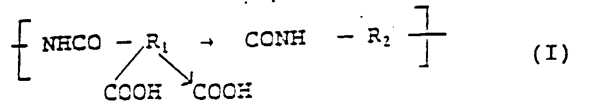 wherein the COOH groups should always take the ortho-positions or adjacent positions with respect to the -CONH- linkages, R₁ represents a tetravalent aromatic or aliphatic hydrocarbon residue, and R₂ represents a divalent aromatic or aliphatic hydrocarbon residue; a compound which becomes basic upon irradiation with actinic rays, represented by formula (II'): 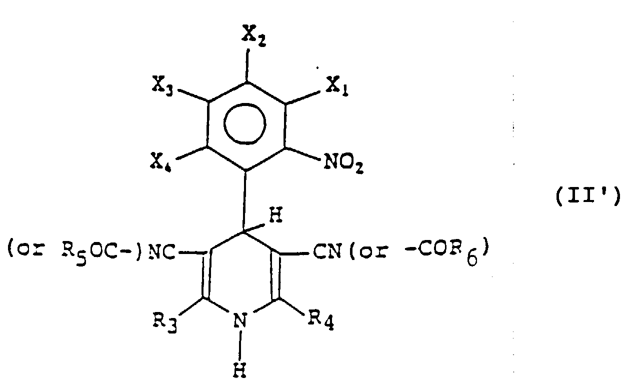 wherein R₃ and R₄ each represents a hydrogen atom or an alkyl group having 1 to 3 carbon atoms, R₅ and R₆ each is one member selected from the group consisting of an alkyl group having 1 to 4 carbon atoms, an alkoxy group having 1 to 4 carbon atoms, an anilino group, a toluidino group, a benzyloxy group, an amino group and a dialkylamino group, and X₁ to X₄ each is one member selected from the group consisting of a hydrogen atom, a fluorine atom, a nitro group, a methoxy group, a dialkylamino group, an amino group, a cyano group and a fluoroalkyl group; and a dissolution accelerator represented by formula (IV): 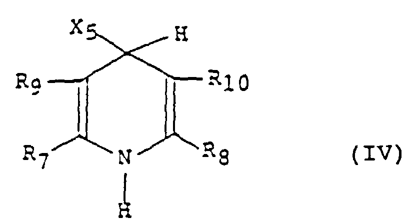 wherein R₇ and R₈ each represents a hydrogen atom or an alkyl group having 1 to 3 carbon atoms, R₉ and R₁₀ each is one member selected from the group consisting of a hydrogen atom, a cyano group, an acetyl group, an amide group and a group of the formula COR₁₁, wherein R₁₁ is one member selected from the group consisting of an alkyl group having 1 to 5 carbon atoms, an alkoxyl group having 1 to 5 carbon atoms, an anilino group, a toluidino group and a benzyloxy group, and X₅ is one member selected from the group consisting of a hydrogen atom, a fluorine atom, an alkyl group having 1 to 3 carbon atoms, a fluoroalkyl group and a phenyl group.

The present invention also provides a photosensitive substrate obtained by coating a surface of a substrate with either of the above heat-resistant negative photoresist compositions.

The present invention still further provides a process for forming a negative pattern which comprises coating a photosensitive liquid on a substrate, said photosensitive liquid being prepared by dissolving the heat-resistant negative photoresist composition of the invention in an organic solvent, drying the resulting coating to form a film on the substrate, irradiating the resulting film with actinic rays through a photomask, heat-treating the irradiated film, and removing unexposed areas of the film by development with a basic development solution.

The resin component used in the heat-resistant negative photoresist composition of the present invention functions as a skeletal substance for resist formation. This component is a polyimide precursor having a structural unit represented by the formula (I) described above. Examples of R₁ in the structural unit represented by the formula (I) include tetravalent aromatic or aliphatic hydrocarbon residues having a skeleton such as benzene, naphthalene, perylene, diphenyl, diphenyl ether, diphenyl sulfone, diphenylpropane, diphenylhexafluoropropane, benzophenone, butane, or cyclobutane. However, R₁ is not limited to those residues. preferred examples of R₁ are tetravalent residues having a skeleton of benzene, diphenyl, or benzophenone. If required and necessary, the groups of R₁ in the resin component can comprise at least two kinds of such residues.

Examples of R₂ include divalent aromatic or aliphatic hydrocarbon residues having a skeleton such as diphenyl ether, diphenyl thioether, benzophenone, diphenylmethane, diphenylpropane, diphenylhexafluoropropane, diphenyl sulfoxide, diphenyl sulfone, biphenyl, pyridine, or benzene. However, R₂ is not limited to those residues. Preferred examples of R₂ are divalent residues having a skeleton of diphenyl ether, diphenyl sulfone, or benzene. If required and necessary, the groups of R₂ in the resin component can comprise at least two kinds of such residues.

The resin component having such a structural unit can be obtained by, for example, reacting substantially equimolar amounts of an aromatic or aliphatic tetracarboxylic dianhydride containing R₁ in the molecule thereof and an aromatic or aliphatic diamine containing R₂ in the molecule thereof in an organic solvent such as N-methyl-2-pyrrolidone, dimethylacetamide, dimethylformamide, dimethyl sulfoxide or hexamethylphosphoramide.

The first heat-resistant negative photoresist composition according to the present invention is characterized in that the resin component having a structural unit represented by the formula (I) contains a photosensitive compound represented by the formulae (II) or (III) described above. That is, the composition contains a photosensitive compound represented by any of the formulae (II) and (III) and becoming basic upon irradiation with actinic rays. This photosensitive compound may be incorporated in combination with a conventional sensitizer if required and necessary. The amount of the photosensitive compound of the formula (II) or (III) added is from 5 to 50 parts by weight, preferably from 10 to 40 parts by weight, per 100 parts by weight of the resin component having a structural unit represented by the formula (I). If the amount of the photosensitive compound added is too small, dissolution inhibition ability of the exposed areas deteriorates and, hence, poor solubility contrast is apt to result. If the amount thereof is too large, the composition may show poor stability during storage in solution state to develop a solid precipitate, which not only adversely affects pattern-forming properties but also leads to a considerable decrease in film thickness upon heat treatment after the formation of a negative pattern, resulting in poor mechanical strength.

In the present invention, the compound of the formula (II) or (III) is presumed to function as follows. When irradiated with actinic rays, the compound undergoes intramolecular rearrangement to change its structure to a structure containing a pyridine skeleton and to become basic. Thereafter, a chemical reaction proceeds upon subsequent heat treatment to cause some interaction either between the resulting basic compound and the resin component having a structural unit represented by the formula (I) or within the basic compound. As a result, the resulting composition has reduced alkali solubility and hence can form a good negative pattern.

Preferred examples of the compound of the formulae (II) and (III) include 2,6-dimethyl-3,5-dicyano-4-(2'-nitrophenyl)-1,4-dihydropyridine, 2,6-dimethyl-3,5-diacetyl-4-(2'-nitrophenyl)-1,4-dihydropyridine, and 2,6-dimethyl-3,5-diacetyl-4-(2',4'-dinitrophenyl)-1,4-dihydropyridine.

The compound represented by-the formula (II) or (III) can be obtained by, for example, reacting a substituted benzaldehyde with 2 mol of aminocrotonitrile per mol of the benzaldehyde in glacial acetic acid with refluxing, or reacting a substituted benzaldehyde with 2 mol of acetylacetone and 1 mol of ammonia per mol of the benzaldehyde in methanol. Alternatively, the desired compound can be obtained by the conventional method for synthesizing 1,4-dihydropyridine derivatives (e.g., *J. Chem. Soc*., 1931, 1835, 1931).

The second heat-resistant negative photoresist composition according to the present invention is characterized in that a dissolution accelerator represented by the formula (IV) described above is further added to the composition comprising the resin component having a structural unit represented by the formula (I) and the photosensitive compound represented by the formula (II'). The dissolution accelerator of the formula (IV) which is contained in the composition is not activated at all by irradiation with actinic rays. It, however, has the effect of accelerating the rate of dissolution of unexposed areas during development, to thereby improve the developing rate and make the composition practically useful.

Preferred examples of the compound of the formula (IV) include 2,6-dimethyl-3,5-dicyano-4-methyl-1,4-dihydropyridine and 2,6-dimethyl-3,5-dicyano-1,4-dihydropyridine.

The amount of the compound of the formula (IV) added as a dissolution accelerator is from 5 to 50 parts by weight, preferably from 5 to 15 parts by weight, per 100 parts by weight of the resin component having a structural unit represented by the formula (I). If the amount of the dissolution accelerator added is too small, acceleration of the dissolution of the resin component in unexposed areas is not expected in development. Too large amounts thereof are undesirable in that a considerable decrease in film thickness may result from the final heat cure or that dissolution inhibition ability of exposed areas may deteriorate.

Preferred amounts and examples and the function of the compounds represented by formula (II') correspond to those of formulae (II) and (III).

One example of the process for forming an image using the heat-resistant negative photoresist composition of the present invention is described below.

First, the resin component represented by the formula (I) is dissolved in an organic solvent such as those described hereinabove, together with either the compound of the formula (II) or (III) or the compounds of the formulae (II') and (IV), to prepare a photosensitive liquid. This photosensitive liquid is then applied on a substrate at a dry thickness of from 1 to 30 µm, preferably from 10 to 20 µm.

The resulting coating film is dried (e.g., at 80°C for 10 minutes) and then exposed to light through an ordinary photomask. Post-exposure baking is then conducted (e.g., at a temperature of 150-200°C, preferably at 170°C or higher for 10 minutes), followed by developing treatment in which the unirradiated areas are removed e.g. by an immersion or spraying method. The developing solution used in the developing treatment is a basic solution preferably capable of completely dissolving and removing the unirradiated areas of the exposed film within a suitable period of time. Examples of such developing solutions include aqueous alkaline solutions of inorganic bases such as sodium hydroxide or potassium hydroxide and aqueous alkaline solutions of organic bases such as propylamine, butylamine, monoethanolamine, tetramethylammonium hydroxide, or choline. Those bases can be used alone or in combination of two or more thereof. The aqueous alkaline solution can contain an organic solvent such as an alcohol, or various kinds of surfactants, if required and necessary.

After development, the resulting film is washed with a rinsing liquid to form a resin image having the desired negative pattern.

The image-bearing film thus obtained is finally subjected to a high-temperature heat treatment (about 200 to 450°C) to allow the polyimide precursor to undergo dehydration cyclization and imidization, thereby obtaining an image-bearing polyimide resist having heat resistance.

The present invention will be explained in more detail by reference to the following examples, but the invention is not construed as being limited thereto.

### EXAMPLE 1

Biphenyltetracarboxylic dianhydride was reacted with an almost equimolar amount of p-phenylenediamine at room temperature for 24 hours in dimethylacetamide at a monomer concentration of 20% by weight, thereby obtaining a solution of a polyimide precursor having a structural unit represented by the formula (I).

To 100 parts by weight, on a solid basis, of the thus-obtained polyimide precursor solution was added 30 parts by weight of the compound represented by the formula (II) wherein R₃ and R₄ each was methyl group and X₁, X₂, X₃, and X₄ each was hydrogen atom (hereinafter referred to as "o-NCN"). The compound added was uniformly dissolved in the solution.

This solution was applied on a silicon wafer with a spin coater at 2,200 rpm for 20 seconds, and predried on an 80°C hot plate for 10 minutes to form a film having a dry thickness of about 18 µm. The film was then exposed through a glass mask to a 436 nm actinic ray emitted by a 250W superhigh-pressure mercury lamp placed at a distance of 30 cm from the film and which had been filtered through a glass filter, for 3 minutes by means of vacuum contact exposure.

After the exposure, the resulting film was heated at 185°C for 10 minutes, developed for 4 minutes with a developing solution composed of 3 wt% aqueous tetramethylammonium hydroxide solution and methyl alcohol (2/1 by volume), and then rinsed with water. As a result, a negative pattern was obtained in which only the irradiated areas remained distinctly on the substrate.

This pattern was subjected to high-temperature heating (400°C for 2 hours) for imidization. As a result, the percentage of the residual film thickness to the initial film thickness was about 75%. The polyimide film finally obtained was of a brown color and showed various properties which were well on practical levels.

### EXAMPLE 2

A negative pattern was formed in the same manner as in Example 1 except that the organic solvent used for polyimide precursor synthesis was changed from dimethylacetamide to N-methyl-2-pyrrolidone.

Although the predrying required a temperature of 100°C, the pattern obtained had good properties as in Example 1.

### EXAMPLE 3

A negative pattern was formed in the same manner as in Example 1 except that in place of o-NCN, the compound represented by the formula (II) wherein R₃ and R₄ each was methyl group, X₁, X₃, and X₄ each was hydrogen atom, and X₂ was nitro group (hereinafter referred to as "2,4-NCN") was used in the same amount. The pattern thus obtained had good properties as in Example 1.

### COMPARATIVE EXAMPLE 1

A pattern was formed in the same manner as in Example 1 except that in place of o-NCN, the compound represented by the formula (II) wherein R₃ and R₄ each was methyl group, X₁, X₃, and X₄ each was hydrogen atom, X₂ was nitro group, and the cyano group at each of the 3- and 5-positions in the 1,4-dihydropyridine ring had been replaced by -COOCH₃ (hereinafter referred to as "2,4-NE") was used in the same amount, and that the post-exposure heating was conducted at 165°C for 10 minutes. However, the pattern thus obtained was a positive pattern in which the unirradiated areas remained on the substrate.

### EXAMPLE 4

A negative pattern was formed in the same manner as in Example 1 except that in place of o-NCN, the compound represented by the formula (III) wherein R₃, R₄, R₅, and R₆ each was methyl group and X₁, X₂, X₃, and X₄ each was hydrogen atom (hereinafter referred to as "o-NA") was used in the same amount. The pattern thus obtained had good properties as in Example 1.

### EXAMPLE 5

A negative pattern was formed in the same manner as in Example 4 except that the organic solvent used for polyimide precursor synthesis was changed from dimethylacetamide to N-methyl-2-pyrrolidone.

Although the predrying required a temperature of 100°C, the pattern obtained had good properties as in Example 4.

### EXAMPLE 6

A negative pattern was formed in the same manner as in Example 4 except that in place of o-NA, the compound represented by the formula (III) wherein R₃, R₄, R₅, and R₆ each was methyl group, X₁, X₃, and X₄ each was hydrogen atom, and X₂ was nitro group (hereinafter referred to as "2,4-NA") was used in the same amount. The pattern thus obtained had good properties as in Example 4.

### EXAMPLE 7

To 100 parts by weight, on a solid basis, of the polyimide precursor solution obtained in Example 1 were added 20 parts by weight of the compound represented by the formula (II') wherein R₃ and R₄ each was methyl group, X₁, X₂, X₃, and X₄ each was hydrogen atom, and R₅ and R₆ each was methyl group (compound "o-NA", see also Example 4) and 10 parts by weight of the compound represented by the formula (IV) wherein X₅ was methyl group, R₇ and R₈ each was methyl group, and R₉ and R₁₀ each was cyano group (hereinafter referred to as "CH₃-CN"). The compounds added were uniformly dissolved in the solution.

A negative pattern was then formed in the same manner as in Example 1 except that the solution obtained above was used. This pattern was subjected to high-temperature heating (400°C for 2 hours) for imidization. As a result, the percentage of the residual film thickness to the initial film thickness was about 75%. The developing rate was as high as about 1.5 to 2 times that in Example 1. The polyimide film finally obtained was of a brown color and showed various properties which were well on practical levels.

### EXAMPLE 8

A negative pattern was formed in the same manner as in Example 7 except that in place of compound "o-NA" used in Example 7, the compound represented by the formula (II') wherein R₃ and R₄ each was methyl group, X₁, X₃, and X₄ each was hydrogen atom, X₂ was nitro group, and R₅ and R₆ each was a methoxy group ("2,4-NE" as in the Comparative Example) was used in the same amount. The pattern thus obtained had good properties as in Example 7.

### EXAMPLE 9

A negative pattern was formed in the same manner as in Example 7 except that in place of compound "o-NA", the compound represented by the formula (II) wherein R₃ and R₄ each was methyl group, X₁, X₃, and X₄ each was hydrogen atom, X₂ was nitro group, and R₅ and R₆ each was methyl group ("2,4-NA" as in Example 6) was used in the same amount, and that the post-heating was conducted at 200°C for 10 minutes.

The pattern thus obtained had good properties as in Example 7.

### EXAMPLE 10

A negative pattern was formed in the same manner as in Example 7 except that the post-heating was conducted at 130°C for 10 minutes and then at 200°C for 10 minutes.

This pattern was subjected to high-temperature heating at 360°C for 2 hours for imidization. The polyimide film thus obtained was superior in mechanical strength to that obtained in Example 7.

### EXAMPLE 11

A negative pattern was formed in the same manner as in Example 7 except that the pre-baking was conducted at 90°C for 30 minutes. This pattern was subjected to high-temperature heating for imidization in the same manner as in Example 10. The polyimide film thus obtained was superior in mechanical strength to that obtained in Example 7.

As described above, when the heat-resistant negative photoresist composition of the present invention is irradiated with actinic rays having a wavelength which is a major absorption wavelength for the specific photosensitive compound contained in the composition, the alkali solubility of the irradiated areas is reduced and a large difference in the rate of dissolution in an alkaline developing solution results between the irradiated areas and the unirradiated areas. Thus, the photoresist composition shows high sensitivity and high resolving power and can form a practically usable negative pattern. Further, by the combined use of a specific dissolution accelerator, development for pattern formation can be conducted within a practical period of time.

Moreover, a desired pattern can be formed from the composition of the present invention at low cost by conducting relatively simple procedures, and products of high quality can be provided. A further advantage of the composition is that since the final product obtained through high-temperature heat treatment has excellent thermal resistance and electrical and mechanical properties, it can be advantageously used in the semiconductor industry as a material for forming a protective or insulating film for solid elements or circuit substrates.

## Claims (Claims for the following Contracting State(s): CH, LI, NL)

1. A heat-resistant negative photoresist composition comprising a resin component having a structural unit represented by formula (I): 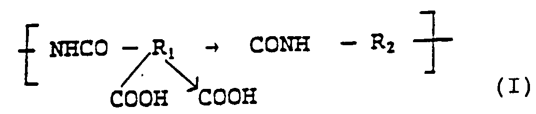 wherein the COOH groups should always take the ortho-positions or adjacent positions with respect to the -CONH- linkages, R₁ represents a tetravalent aromatic or aliphatic hydrocarbon residue, and R₂ represents a divalent aromatic or aliphatic hydrocarbon residue; and a compound which becomes basic upon irradiation with actinic rays, represented by formula (II) or formula (III): 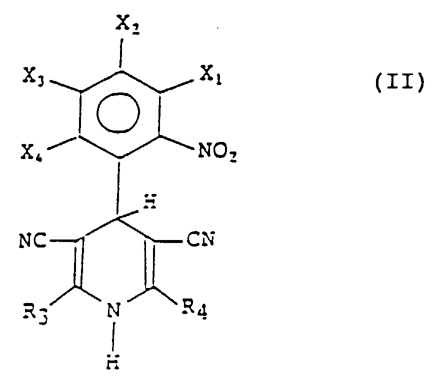 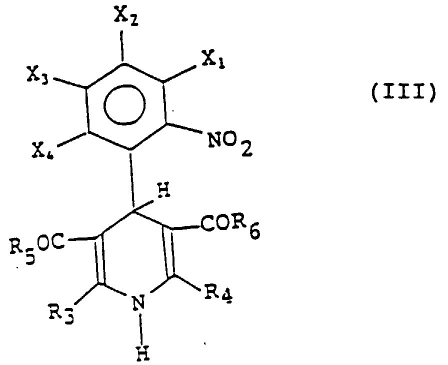 wherein R₃ and R₄ each represents a hydrogen atom or an alkyl group having 1 to 3 carbon atoms, R₅ and R₆ each is an alkyl group having 1 to 4 carbon atoms, and X₁ to X₄ each is one member selected from the group consisting of a hydrogen atom, a fluorine atom, a nitro group, a methoxy group, a dialkylamino group, an amino group, a cyano group and a fluoroalkyl group.

2. The heat-resistant negative photoresist composition of claim 1, wherein R₁ in the structural unit represented by the formula (I) is a tetravalent aromatic or aliphatic hydrocarbon residue having a skeleton of benzene, naphthalene, perylene, biphenyl, diphenyl ether, diphenyl sulfone, diphenylpropane, diphenylhexafluoropropane, benzophenone, butane or cyclobutane.

3. The heat-resistant negative photoresist composition of claim 1, wherein R₂ in the structural unit represented by the formula (I) is a divalent aromatic or aliphatic hydrocarbon residue having a skeleton of diphenyl ether, diphenyl thioether, benzophenone, diphenylmethane, diphenylpropane, diphenylhexafluoropropane, diphenyl sulfone, biphenyl, pyridine or benzene.

4. The heat-resistant negative photoresist composition of claim 1, wherein the resin component is obtained by reacting an aromatic or aliphatic tetracarboxylic dianhydride containing R₁ in the molecule thereof and an aromatic or aliphatic diamine containing R₂ in the molecule thereof in substantially equimolar amounts in an organic solvent.

5. The heat-resistant negative photoresist composition of claim 1, wherein the compound of the formula (II) or (III) is used in an amount of from 5 to 50 parts by weight per 100 parts by weight of the resin component.

6. The heat-resistant negative photoresist composition of claim 5, wherein the amount of the compound of the formula (II) or (III) is from 10 to 40 parts by weight per 100 parts by weight of the resin component.

7. The heat-resistant negative photoresist composition of claim 1, wherein the compound of the formula (III) is 2,6-dimethyl-3,5-diacetyl-4-(2',4'-dinitrophenyl)-1,4-dihydropyridine.

8. A heat-resistant negative photoresist composition comprising a resin component having a structural unit represented by formula (I): 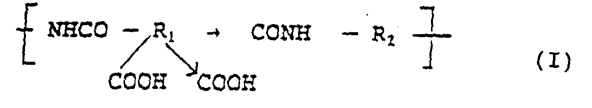 wherein the COOH groups should always take the ortho-positions or adjacent positions with respect to the -CONH- linkages, R₁ represents a tetravalent aromatic or aliphatic hydrocarbon residue, and R₂ represents a divalent aromatic or aliphatic hydrocarbon residue; a compound which becomes basic upon irradiation with actinic rays, represented by formula (II'): 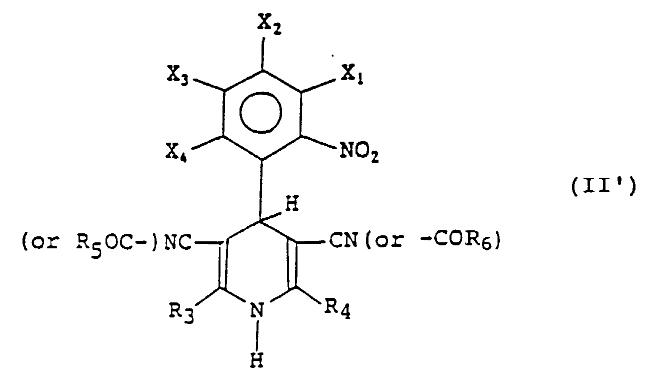 wherein R₃ and R₄ each represents a hydrogen atom or an alkyl group having 1 to 3 carbon atoms, R₅ and R₆ each is one member selected from the group consisting of an alkyl group having 1 to 4 carbon atoms, an alkoxy group having 1 to 4 carbon atoms, an anilino group, a toluidino group, a benzyloxy group, an amino group and a dialkylamino group, and X₁ to X₄ each is one member selected from the group consisting of a hydrogen atom, a fluorine atom, a nitro group, a methoxy group, a dialkylamino group, an amino group, a cyano group and a fluoroalkyl group; and a dissolution accelerator represented by formula (IV): 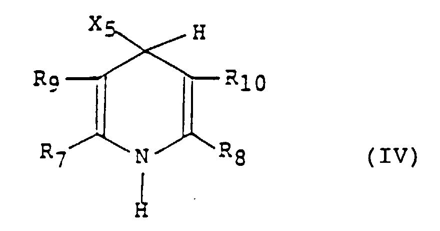 wherein R₇ and R₈ each represents a hydrogen atom or an alkyl group having 1 to 3 carbon atoms, R₉ and R₁₀ each is one member selected from the group consisting of a hydrogen atom, a cyano group, an acetyl group, an amide group and a group of the formula COR₁₁, wherein R₁₁ is one member selected from the group consisting of an alkyl group having 1 to 5 carbon atoms, an alkoxyl group having 1 to 5 carbon atoms, an anilino group, a toluidino group and a benzyloxy group, and X₅ is one member selected from the group consisting of a hydrogen atom, a fluorine atom, an alkyl group having 1 to 3 carbon atoms, a fluoroalkyl group and a phenyl group.

9. The heat-resistant negative photoresist of claim 8, wherein R₁ in the structural unit represented by the formula (I) is a tetravalent aromatic or aliphatic hydrocarbon residue having a skeleton of benzene, naphthalene, perylene, biphenyl, diphenyl ether, diphenyl sulfone, diphenylpropane, diphenylhexafluoropropane, benzophenone, butane or cyclobutane.

10. The heat-resistant negative photoresist composition of claim 8, wherein R₂ in the structural unit represented by the formula (I) is a divalent aromatic or aliphatic hydrocarbon residue having a skeleton of diphenyl ether, diphenyl thioether, benzophenone, diphenylmethane, diphenylpropane, diphenylhexafluoropropane, diphenyl sulfone, biphenyl, pyridine or benzene.

11. The heat-resistant negative photoresist composition of claim 8, wherein the resin component is obtained by reacting an aromatic or aliphatic tetracarboxylic dianhydride containing R₁ in the molecule thereof and an aromatic or aliphatic diamine containined R₂ in the molecule thereof in substantially equimolar amounts in an organic solvent.

12. The heat-resistant negative photoresist composition of claim 8, wherein the compound of the formula (II') is used in an amount of from 5 to 50 parts by weight per 100 parts by weight of the resin component.

13. The heat-resistant negative photoresist composition of claim 12, wherein the amount of the compound of the formula (II') is from 10 to 40 parts by weight per 100 parts by weight of the resin component.

14. The heat-resistant negative photoresist composition of claim 8, wherein the compound of the formula (II') is 2,6-dimethyl-3,5-dicyano-4-(2'nitrophenyl)-1,4-dihydropyridine, 2,6-dimethyl-3,5-diacetyl-4-(2'-nitrophenyl)-1,4-dihydropyridine or 2,6-dimethyl-3,5-diacetyl-4-(2',4'-dinitrophenyl)-1,4-dihydropyridine.

15. The heat-resistant negative photoresist composition of claim 8, wherein the dissolution accelerator is 2,6-dimethyl-3,5-dicyano-4-methyl-1,4-dihydropyridine or 2,6-dimethyl-3,5-dicyano-1,4-dihydropyridine.

16. The heat resistant negative photoresist composition of claim 8, wherein the dissolution accelerator is used in an amount of from 5 to 50 parts by weight per 100 parts by weight of the resin component.

17. The heat-resistant negative photoresist composition of claim 16, wherein the amount of the dissolution accelerator is from 5 to 15 parts by weight per 100 parts by weight of the resin component.

18. A photosensitive substrate obtained by coating a surface of a substrate with the heat-resistant negative photoresist composition of claim 1 or 8.

19. A process for forming a negative pattern which comprises
coating a photosensitive liquid on a substrate, said photosensitive liquid being prepared by dissolving the heat-resistant negative photoresist composition of claim 1 or 8 in an organic solvent,
drying the resulting coating to form a film on the substrate,
irradiating the resulting film with actinic rays through a photomask,
heat-treating the irradiated film, and
removing unexposed areas of the film by development with a basic development solution.

20. The process of claim 19, wherein the heat treatment is conducted at a temperature of 170°C or higher.

## Claims (Claims for the following Contracting State(s): BE, DE, FR, GB)

1. A heat-resistant negative photoresist composition comprising a resin component having a structural unit represented by formula (I): 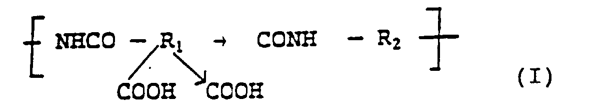 wherein the COOH groups should always take the ortho-positions or adjacent positions with respect to the -CONH- linkages, R₁ represents a tetravalent aromatic or aliphatic hydrocarbon residue, and R₂ represents a divalent aromatic or aliphatic hydrocarbon residue; and a compound which becomes basic upon irradiation with actinic rays, represented by formula (II) or formula (III): 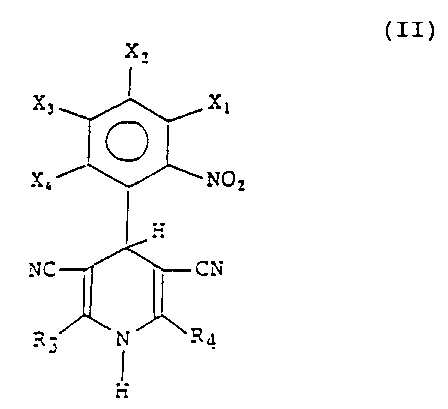 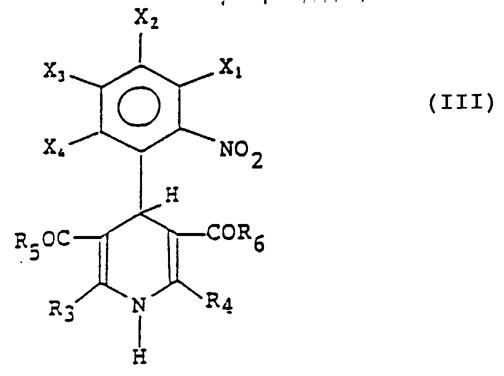 wherein R₃ and R₄ each represents a hydrogen atom or an alkyl group having 1 to 3 carbon atoms, R₅ and R₆ each is an alkyl group having 1 to 4 carbon atoms, and X₁ to X₄ each is one member selected from the group consisting of a hydrogen atom, a fluorine atom, a nitro group, a methoxy group, a dialkylamino group, an amino group, a cyano group and a fluoroalkyl group,
with the proviso that 2,6-dimethyl-3,5-dicyano-4-(2'-nitrophenyl)-1,4-dihydropyridine and 2,6-dimethyl-3,5-diacetyl-4-(2'nitrophenyl)-1,4-dihydropyridine are excluded.

2. The heat-resistant negative photoresist composition of claim 1, wherein R₁ in the structural unit represented by the formula (I) is a tetravalent aromatic or aliphatic hydrocarbon residue having a skeleton of benzene, naphthalene, perylene, biphenyl, diphenyl ether, diphenyl sulfone, diphenylpropane, diphenylhexafluoropropane, benzophenone, butane or cyclobutane.

3. The heat-resistant negative photoresist composition of claim 1, wherein R₂ in the structural unit represented by the formula (I) is a divalent aromatic or aliphatic hydrocarbon residue having a skeleton of diphenyl ether, diphenyl thioether, benzophenone, diphenylmethane, diphenylpropane, diphenylhexafluoropropane, diphenyl sulfone, biphenyl, pyridine or benzene.

4. The heat-resistant negative photoresist composition of claim 1, wherein the resin component is obtained by reacting an aromatic or aliphatic tetracarboxylic dianhydride containing R₁ in the molecule thereof and an aromatic or aliphatic diamine containing R₂ in the molecule thereof in substantially equimolar amounts in an organic solvent.

5. The heat-resistant negative photoresist composition of claim 1, wherein the compound of the formula (II) or (III) is used in an amount of from 5 to 50 parts by weight per 100 parts by weight of the resin component.

6. The heat-resistant negative photoresist composition of claim 5, wherein the amount of the compound of the formula (II) or (III) is from 10 to 40 parts by weight per 100 parts by weight of the resin component.

7. The heat-resistant negative photoresist composition of claim 1, wherein the compound of the formula (III) is 2,6-dimethyl-3,5-diacetyl-4-(2',4'-dinitrophenyl)-1,4-dihydropyridine.

8. A heat-resistant negative photoresist composition comprising a resin component having a structural unit represented by formula (I): 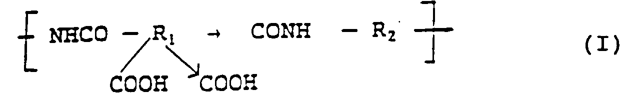 wherein the COOH groups should always take the ortho-positions or adjacent positions with respect to the -CONH- linkages, R₁ represents a tetravalent aromatic or aliphatic hydrocarbon residue, and R₂ represents a divalent aromatic or aliphatic hydrocarbon residue; a compound which becomes basic upon irradiation with actinic rays, represented by formula (II'): 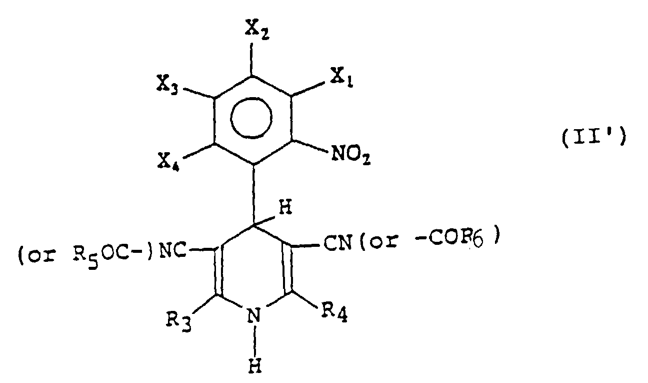 wherein R₃ and R₄ each represents a hydrogen atom or an alkyl group having 1 to 3 carbon atoms, R₅ and R₆ each is one member selected from the group consisting of an alkyl group having 1 to 4 carbon atoms, an alkoxy group having 1 to 4 carbon atoms, an anilino group, a toluidino group, a benzyloxy group, an amino group and a dialkylamino group, and X₁ to X₄ each is one member selected from the group consisting of a hydrogen atom, a fluorine atom, a nitro group, a methoxy group, a dialkylamino group, an amino group, a cyano group and a fluoroalkyl group; and a dissolution accelerator represented by formula (IV) : 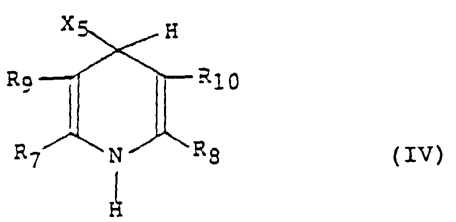 wherein R₇ and R₈ each represents a hydrogen atom or an alkyl group having 1 to 3 carbon atoms, R₉ and R₁₀ each is one member selected from the group consisting of a hydrogen atom, a cyano group, an acetyl group, an amide group and a group of the formula COR₁₁, wherein R₁₁ is one member selected from the group consisting of an alkyl group having 1 to 5 carbon atoms, an alkoxyl group having 1 to 5 carbon atoms, an anilino group, a toluidino group and a benzyloxy group, and X₅ is one member selected from the group consisting of a hydrogen atom, a fluorine atom, an alkyl group having 1 to 3 carbon atoms, a fluoroalkyl group and a phenyl group.

9. The heat-resistant negative photoresist of claim 8, wherein R₁ in the structural unit represented by the formula (I) is a tetravalent aromatic or aliphatic hydrocarbon residue having a skeleton of benzene, naphthalene, perylene, biphenyl, diphenyl ether, diphenyl sulfone, diphenylpropane, diphenylhexafluoropropane, benzophenone, butane or cyclobutane.

10. The heat-resistant negative photoresist composition of claim 8, wherein R₂ in the structural unit represented by the formula (I) is a divalent aromatic or aliphatic hydrocarbon residue having a skeleton of diphenyl ether, diphenyl thioether, benzophenone, diphenylmethane, diphenylpropane, diphenylhexafluoropropane, diphenyl sulfone, biphenyl, pyridine or benzene.

11. The heat-resistant negative photoresist composition of claim 8, wherein the resin component is obtained by reacting an aromatic or aliphatic tetracarboxylic dianhydride containing R₁ in the molecule thereof and an aromatic or aliphatic diamine containined R₂ in the molecule thereof in substantially equimolar amounts in an organic solvent.

12. The heat-resistant negative photoresist composition of claim 8, wherein the compound of the formula (II') is used in an amount of from 5 to 50 parts by weight per 100 parts by weight of the resin component.

13. The heat-resistant negative photoresist composition of claim 12, wherein the amount of the compound of the formula (II') is from 10 to 40 parts by weight per 100 parts by weight of the resin component.

14. The heat-resistant negative photoresist composition of claim 8, wherein the compound of the formula (II') is 2,6-dimethyl-3,5-dicyano-4-(2'nitrophenyl)-1,4-dihydropyridine, 2,6-dimethyl-3,5-diacetyl-4-(2'-nitrophenyl)-1,4-dihydropyridine or 2,6-dimethyl-3,5-diacetyl-4-(2',4'-dinitrophenyl)-1,4-dihydropyridine.

15. The heat-resistant negative photoresist composition of claim 8, wherein the dissolution accelerator is 2,6-dimethyl-3,5-dicyano-4-methyl-1,4-dihydropyridine or 2,6-dimethyl-3,5-dicyano-1,4-dihydropyridine.

16. The heat resistant negative photoresist composition of claim 8, wherein the dissolution accelerator is used in an amount of from 5 to 50 parts by weight per 100 parts by weight of the resin component.

17. The heat-resistant negative photoresist composition of claim 16, wherein the amount of the dissolution accelerator is from 5 to 15 parts by weight per 100 parts by weight of the resin component.

18. A photosensitive substrate obtained by coating a surface of a substrate with the heat-resistant negative photoresist composition of claim 1 or 8.

19. A process for forming a negative pattern which comprises
coating a photosensitive liquid on a substrate, said photosensitive liquid being prepared by dissolving the heat-resistant negative photoresist composition of claim 1 or 8 in an organic solvent,
drying the resulting coating to form a film on the substrate,
irradiating the resulting film with actinic rays through a photomask,
heat-treating the irradiated film, and
removing unexposed areas of the film by development with a basic development solution.

20. The process of claim 19, wherein the heat treatment is conducted at a temperature of 170°C or higher.

## Patentansprüche (Patentansprüche für folgende(n) Vertragsstaat(en): CH, LI, NL)

1. Hitzebeständige, negativ arbeitende Photoresistzusammensetzung,
umfassend einen Harzbestandteil mit einer Struktureinheit der Formel (I): 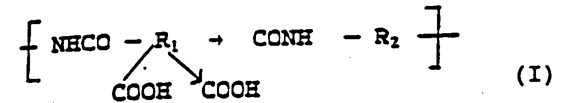 in der die COOH-Gruppen immer die ortho-Positionen oder die benachbarten Positionen bezüglich den -CONH-Bindungen einnehmen, R₁ einen vierwertigen, aromatischen oder aliphatischen Kohlenwasserstoffrest bedeutet, und R₂ einen zweiwertigen, aromatischen oder aliphatischen Kohlenwasserstoffrest bedeutet,
und eine Verbindung der Formel (II) oder Formel (III), die bei der Bestrahlung mit photochemischen wirksamen Strahlen basisch wird: 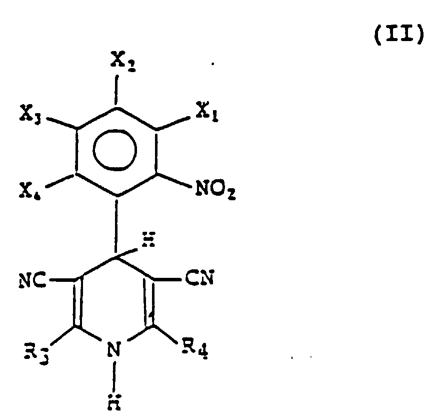 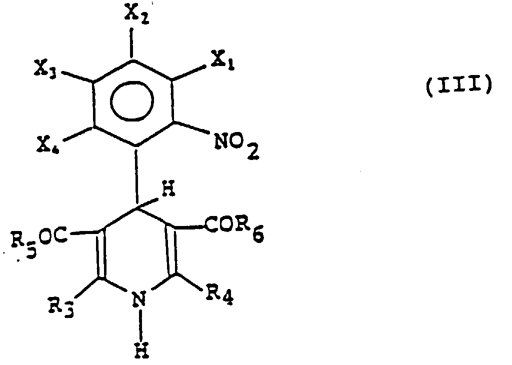 in der R₃ und R₄ ein Wasserstoffatom oder einen Alkylrest mit 1 bis 3 Kohlenstoffatomen bedeuten, R₅ und R₆ jeweils einen Alkylrest mit 1 bis 4 Kohlenstoffatomen bedeuten, und X₁ bis X₄ jeweils eine Gruppe bedeuten, die aus der Gruppe bestehend aus einem Wasserstoffatom, einem Fluoratom, einer Nitrogruppe, einer Methoxygruppe, einem Dialkylaminorest, einer Aminogruppe, einer Cyanogruppe und einem Fluoralkylrest ausgewählt ist.

2. Hitzbeständige, negativ arbeitende Photoresistzusammensetzungen nach Anspruch 1, wobei R₁ in der Struktureinheit der Formel (I) ein vierwertiger, aromatischer oder aliphatischer Kohlenwasserstoffrest mit einem Benzol-, Naphthalin-, Perylen-, Biphenyl-, Diphenylether-, Diphenylsulfon-, Diphenylpropan-, Diphenylhexafluorpropan-, Benzophenon-, Butan- oder Cyclobutangerüst ist.

3. Hitzebeständige, negativ arbeitende Photoresistzusammensetzung nach Anspruch 1, wobei R₂ in der Struktureinheit der Formel (I) ein zweiwertiger aromatischer oder aliphatischer Kohlenwasserstoffrest mit einem Diphenylether-, Diphenylthioether-, Benzophenon-, Diphenylmethan-, Diphenylpropan-, Diphenylhexafluorpropan-, Diphenylsulfon-, Biphenyl-, Pyridin- oder Benzolgerüst ist.

4. Hitzebeständige, negativ arbeitende Photoresistzusammensetzung nach Anspruch 1, wobei der Harzbestandteil durch Umsetzung eines aromatischen oder aliphatischen Tetracarbonsäuredianhydrids, das R₁ im Molekül enthält, und eines aromatischen oder aliphatischen Diamins, das R₂ im Molekül enthält, in im wesentlichen äquimolaren Mengen in einem organischen Lösungsmittel erhalten wird.

5. Hitzebeständige, negativ arbeitende Photoresistzusammensetzung nach Anspruch 1, wobei die Verbindung der Formel (II) oder (III) in einer Menge von 5 bis 50 Gewichtsteilen pro 100 Gewichtsteilen des Harzbestandteils verwendet wird.

6. Hitzebeständige, negativ arbeitende Photoresistzusammensetzung nach Anspruch 5, wobei die Menge der Verbindung der Formel (II) oder (III) 10 bis 40 Gewichtsteile pro 100 Gewichtsteilendes Harzbestandteils beträgt.

7. Hitzebeständige, negativ arbeitende Photoresistzusammensetzung nach Anspruch 1, wobei die Verbindung der Formel (III) 2,6-Dimethyl-3,5-diacetyl-4-(2',4'-dinitrophenyl)-1,4-dihydropyridin ist.

8. Hitzebeständige, negativ arbeitende Photoresistzusammensetzung, umfassend einen Harzbestandteil mit einer Struktureinheit der Formel (I): 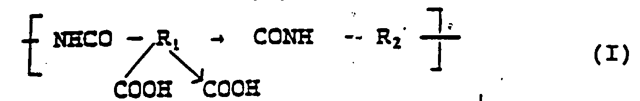 in der die COOH-Gruppen immer die ortho-Positionen oder die benachbarten Positionen bezüglich der -CONH-Bindungen einnehmen, R₁ einen vierwertigen, aromatischen oder aliphatischen Kohlenwasserstoffrest bedeutet und R₂ einen zweiwertigen, aromatischen oder aliphatischen Kohlenwasserstoffrest bedeutet,
eine Verbindung der Formel (II'), die bei der Bestrahlung mit photochemisch wirksamen Strahlen basisch wird: 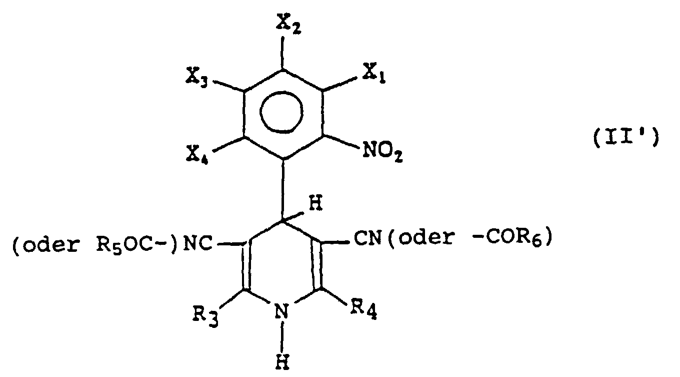 in der R₃ und R₄ jeweils ein Wasserstoffatom oder einen Alkylrest mit 1 - 3 Kohlenstoffatomen bedeuten, R₅ und R₆ jeweils eine Gruppe bedeuten, die aus der Gruppe bestehend aus einem Alkylrest mit 1 - 4 Kohlenstoffatomen, einem Alkoxyrest mit 1 - 4 Kohlenstoffatomen, einer Anilinogruppe, einer Toluidinogruppe, einer Benzyloxygruppe, einer Aminogruppe und einem Dialkylaminorest ausgewählt ist, und X₁ bis X₄ jeweils eine Gruppe bedeuten, die aus der Gruppe bestehend aus einem Wasserstoffatom, einem Fluoratom, einer Nitrogruppe, einer Methoxygruppe, einem Dialkylaminorest, einer Aminogruppe, einer Cyanogruppe und einem Fluoralkylrest ausgewählt ist,
und einen Auflösungsbeschleuniger der Formel (IV) : 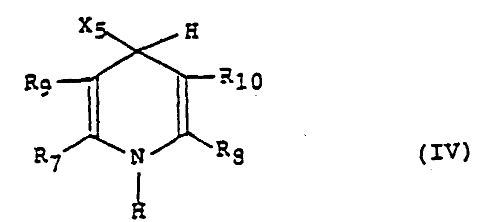 in der R₇ und R₈ jeweils ein Wasserstoffatom oder einen Alkylrest mit 1 - 3 Kohlenstoffatomen bedeuten, R₉ und R₁₀ jeweils eine Gruppe bedeuten, die aus der Gruppe bestehend aus einem Wasserstoffatom, einer Cyanogruppe, einer Acetylgruppe, einer Amidgruppe und einer Gruppe der Formel COR₁₁ ausgewählt ist, wobei R₁₁ eine Gruppe bedeutet, die aus der Gruppe bestehend aus einem Alkylrest mit 1 - 5 Kohlenstoffatomen, einem Alkoxyrest mit 1 - 5 Kohlenstoffatomen, einer Anilinogruppe, einer Toluidinogruppe und einer Benzyloxygruppe ausgewählt ist, und X₅ eine Gruppe bedeutet, die aus der Gruppe bestehend aus einem Wasserstoffatom, einem Fluoratom, einem Alkylrest mit 1 - 3 Kohlenstoffatomen, einem Fluoralkylrest und einer Phenylgruppe ausgewählt ist.

9. Hitzebeständige, negativ arbeitende Photoresistzusammensetzung nach Anspruch 8, wobei R₁ in der Struktureinheit der Formel (I) einen vierwertigen, aromatischen oder aliphatischen Kohlenwasserstoffrest mit einem Benzol-, Naphthalin-, Perylen-, Biphenyl-, Diphenylether-, Diphenylsulfon-, Diphenylpropan-, Diphenylhexafluorpropan-, Benzophenon-, Butan- oder Cyclobutangerüst ist.

10. Hitzebeständige, negativ arbeitende Photoresistzusammensetzung nach Anspruch 8, wobei R₂ in der Struktureinheit der Formel (I) ein zweiwertiger, aromatischer oder aliphatischer Kohlenwasserstoffrest mit einem Diphenylether-, Diphenylthioether-, Benzophenon-, Diphenylmethan-, Diphenylpropan-, Diphenylhexafluorpropan-, Diphenylsulfon-, Biphenyl-, Pyridin- oder Benzolgerüst ist.

11. Hitzebeständige, negativ arbeitende Photoresistzusammensetzung nach Anspruch 8, wobei der Harzbestandteil durch Umsetzung eines aromatischen oder aliphatischen Tetracarbonsäuredianhydrids, das R₁ im Molekül enthält, und eines aromatischen oder aliphatischen Diamins, das R₂ im Molekül enthält,in im wesentlichen äquimolaren Mengen in einem organischen Lösungsmittel erhalten wird.

12. Hitzebeständige, negativ arbeitende Photoresistzusammensetzung nach Anspruch 8, wobei die Verbindung der Formel (II') in einer Menge von 5 - 50 Gewichtsteilen pro 100 Gewichtsteilen des Harzbestandteils verwendet wird.

13. Hitzebeständige, negativ arbeitende Photoresistzusammensetzung nach Anspruch 12, wobei die Menge der Verbindung der Formel (II') 10 - 40 Gewichtsteile pro 100 Gewichtsteilen des Harzbestandteils beträgt.

14. Hitzebeständige, negativ arbeitende Photoresistzusammensetzung nach Anspruch 8, wobei die Verbindung der Formel (II') 2,6-Dimethyl-3,5-dicyano-4-(2'-nitrophenyl)-1,4-dihydropyridin, 2,6-Dimethyl-3,5-diacetyl-4-(2'-nitrophenyl)-1,4-dihydropyridin oder 2,6-Dimethyl-3,5-diacetyl-4-(2',4'-dinitrophenyl)-1,4-dihydropyridin ist.

15. Hitzebeständige, negativ arbeitende Photoresistzusammensetzung nach Anspruch 8, wobei der Auflösungsbeschleuniger 2,6-Dimethyl-3,5-dicyano-4-methyl-1,4-dihydropyridin oder 2,6-Dimethyl-3,5-dicyano-1,4-dihydropyridin ist.

16. Hitzebeständige, negativ arbeitende Photoresistzusammensetzung nach Anspruch 8, wobei der Auflösungsbeschleuniger in einer Menge von 5 - 50 Gewichtsteilen pro 100 Gewichtsteilen des Harzbestandteils verwendet wird.

17. Hitzebeständige, negativ arbeitende Photoresistzusammensetzung nach Anspruch 16, wobei die Menge an Auflösungsbeschleuniger 5 - 15 Gewichtsteile pro 100 Gewichtsteilen des Harzbestandteils beträgt.

18. Lichtempfindliches Substrat, erhältlich durch Beschichten einer Oberfläche eines Substrats mit der hitzebeständigen, negativ arbeitenden Photoresistzusammensetzung nach Anspruch 1 oder 8.

19. Verfahren zur Herstellung eines negativen Musters, umfassend
das Aufbringen einer lichtempfindlichen Flüssigkeit auf ein Substrat, wobei die lichtempfindliche Flüssigkeit durch Auflösen der hitzebeständigen, negativ arbeitenden Zusammensetzung nach Anspruch 1 oder 8 in einem organischen Lösungsmittel hergestellt wird,
Trocknen der erhaltenen Beschichtung, wobei ein Film auf dem Substrat hergestellt wird,
Bestrahlung des erhaltenen Films mit photochemisch wirksamen Strahlen durch eine Photomaske,
Hitzebehandlung des bestrahlten Films, und
Entfernen der unbelichteten Flächen des Films durch Entwicklung mit einer basischen Entwicklungslösung.

20. Verfahren nach Anspruch 19, wobei die Hitzebehandlung bei einer Temperatur von 170 °C oder höher ausgeführt wird.

## Patentansprüche (Patentansprüche für folgende(n) Vertragsstaat(en): BE, DE, FR, GB)

1. Hitzebeständige, negativ arbeitende Photoresistzusammensetzung,
umfassend einen Harzbestandteil mit einer Struktureinheit der Formel (I) : 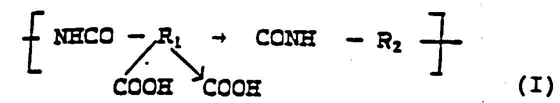 in der die COOH-Gruppen immer die ortho-Positionen oder die benachbarten Positionen bezüglich den -CONH-Bindungen einnehmen, R₁ einen vierwertigen, aromatischen oder aliphatischen Kohlenwasserstoffrest bedeutet, und R₂ einen zweiwertigen, aromatischen oder aliphatischen Kohlenwasserstoffrest bedeutet,
und eine Verbindung der Formel (II) oder Formel (III), die bei der Bestrahlung mit photochemischen wirksamen Strahlen basisch wird: 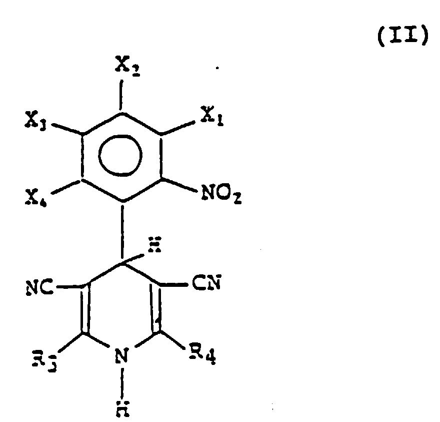 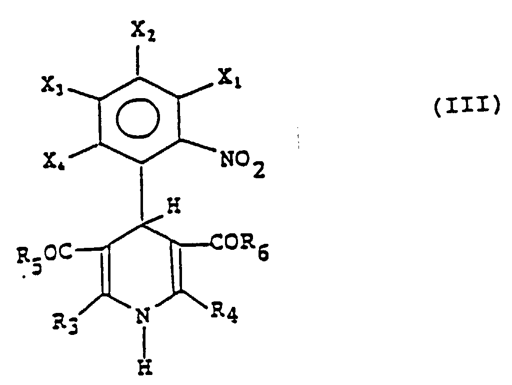 in der R₃ und R₄ ein Wasserstoffatom oder einen Alkylrest mit 1 bis 3 Kohlenstoffatomen bedeuten, R₅ und R₆ jeweils einen Alkylrest mit 1 bis 4 Kohlenstoffatomen bedeuten, und X₁ bis X₄ jeweils eine Gruppe bedeuten, die aus der Gruppe bestehend aus einem Wasserstoffatom, einem Fluoratom, einer Nitrogruppe, einer Methoxygruppe, einem Dialkylaminorest, einer Aminogruppe, einer Cyanogruppe und einem Fluoralkylrest ausgewählt ist, mit der Maßgabe, daß 2,6-Dimethyl-3,5-dicyano-4-(2'-nitrophenyl)-1,4-dihydropyridin und 2,6-Dimethyl-3,5-diacetyl-4-(2'-nitrophenyl)-1,4-dihydropyridin ausgenommen sind.

2. Hitzbeständige, negativ arbeitende Photoresistzusammensetzungen nach Anspruch 1, wobei R₁ in der Struktureinheit der Formel (I) ein vierwertiger, aromatischer oder aliphatischer Kohlenwasserstoffrest mit einem Benzol-, Naphthalin-, Perylen-, Biphenyl-, Diphenylether-, Diphenylsulfon-, Diphenylpropan-, Diphenylhexafluorpropan-, Benzophenon-, Butan- oder Cyclobutangerüst ist.

3. Hitzebeständige, negativ arbeitende Photoresistzusammensetzung nach Anspruch 1, wobei R₂ in der Struktureinheit der Formel (I) ein zweiwertiger aromatischer oder aliphatischer Kohlenwasserstoffrest mit einem Diphenylether-, Diphenylthioether-, Benzophenon-, Diphenylmethan-, Diphenylpropan-, Diphenylhexafluorpropan-, Diphenylsulfon-, Biphenyl-, Pyridin- oder Benzolgerüst ist.

4. Hitzebeständige, negativ arbeitende Photoresistzusammensetzung nach Anspruch 1, wobei der Harzbestandteil durch Umsetzung eines aromatischen oder aliphatischen Tetracarbonsäuredianhydrids, das R₁ im Molekül enthält, und eines aromatischen oder aliphatischen Diamins, das R₂ im Molekül enthält, in im wesentlichen äquimolaren Mengen in einem organischen Lösungsmittel erhalten wird.

5. Hitzebeständige, negativ arbeitende Photoresistzusammensetzung nach Anspruch 1, wobei die Verbindung der Formel (II) oder (III) in einer Menge von 5 bis 50 Gewichtsteilen pro 100 Gewichtsteilen des Harzbestandteils verwendet wird.

6. Hitzebeständige, negativ arbeitende Photoresistzusammensetzung nach Anspruch 5, wobei die Menge der Verbindung der Formel (II) oder (III) 10 bis 40 Gewichtsteile pro 100 Gewichtsteilen des Harzbestandteils beträgt.

7. Hitzebeständige, negativ arbeitende Photoresistzusammensetzung nach Anspruch 1, wobei die Verbindung der Formel (III) 2,6-Dimethyl-3,5-diacetyl-4-(2',4'-dinitrophenyl)-1,4-dihydropyridin ist.

8. Hitzebeständige, negativ arbeitende Photoresistzusammensetzung, umfassend einen Harzbestandteil mit einer Struktureinheit der Formel (I): 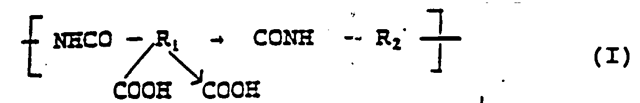 in der die COOH-Gruppen immer die ortho-Positionen oder die benachbarten Positionen bezüglich der -CONH-Bindungen einnehmen, R₁ einen vierwertigen, aromatischen oder aliphatischen Kohlenwasserstoffrest bedeutet und R₂ einen zweiwertigen, aromatischen oder aliphatischen Kohlenwasserstoffrest bedeutet,
eine Verbindung der Formel (II'), die bei der Bestrahlung mit photochemisch wirksamen Strahlen basisch wird: 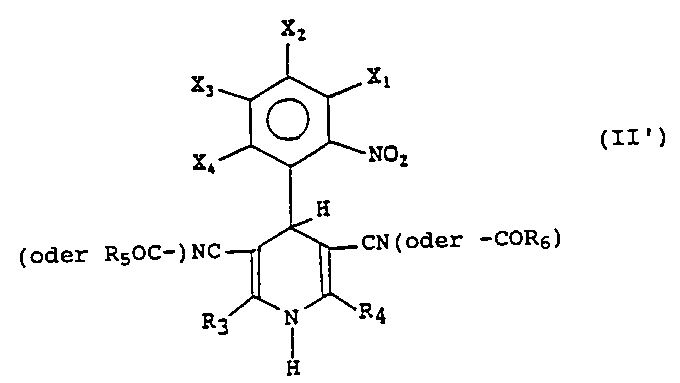 in der R₃ und R₄ jeweils ein Wasserstoffatom oder einen Alkylrest mit 1 - 3 Kohlenstoffatomen bedeuten, R₅ und R₆ jeweils eine Gruppe bedeuten, die aus der Gruppe bestehend aus einem Alkylrest mit 1 - 4 Kohlenstoffatomen, einem Alkoxyrest mit 1 - 4 Kohlenstoffatomen, einer Anilinogruppe, einer Toluidinogruppe, einer Benzyloxygruppe, einer Aminogruppe und einem Dialkylaminorest ausgewählt ist, und X₁ bis X₄ jeweils eine Gruppe bedeuten, die aus der Gruppe bestehend aus einem Wasserstoffatom, einem Fluoratom, einer Nitrogruppe, einer Methoxygruppe, einem Dialkylaminorest, einer Aminogruppe, einer Cyanogruppe und einem Fluoralkylrest ausgewählt ist,
und einen Auflösungsbeschleuniger der Formel (IV) : 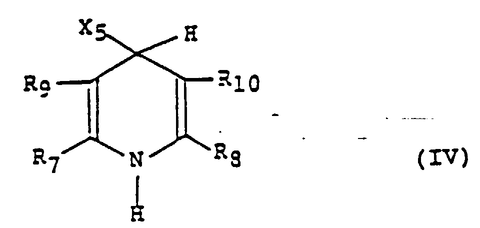 in der R₇ und R₈ jeweils ein Wasserstoffatom oder einen Alkylrest mit 1 - 3 Kohlenstoffatomen bedeuten, R₉ und R₁₀ jeweils eine Gruppe bedeuten, die aus der Gruppe bestehend aus einem Wasserstoffatom, einer Cyanogruppe, einer Acetylgruppe, einer Amidgruppe und einer Gruppe der Formel COR₁₁ ausgewählt ist, wobei R₁₁ eine Gruppe bedeutet, die aus der Gruppe bestehend aus einem Alkylrest mit 1 - 5 Kohlenstoffatomen, einem Alkoxyrest mit 1 - 5 Kohlenstoffatomen, einer Anilinogruppe, einer Toluidinogruppe und einer Benzyloxygruppe ausgewählt ist, und X₅ eine Gruppe bedeutet, die aus der Gruppe bestehend aus einem Wasserstoffatom, einem Fluoratom, einem Alkylrest mit 1 - 3 Kohlenstoffatomen, einem Fluoralkylrest und einer Phenylgruppe ausgewählt ist.

9. Hitzebeständige, negativ arbeitende Photoresistzusammensetzung nach Anspruch 8, wobei R₁ in der Struktureinheit der Formel (I) einen vierwertigen, aromatischen oder aliphatischen Kohlenwasserstoffrest mit einem Benzol-, Naphthalin-, Perylen-, Biphenyl-, Diphenylether-, Diphenylsulfon-, Diphenylpropan-, Diphenylhexafluorpropan-, Benzophenon-, Butan- oder Cyclobutangerüst ist.

10. Hitzebeständige, negativ arbeitende Photoresistzusammensetzung nach Anspruch 8, wobei R₂ in der Struktureinheit der Formel (I) ein zweiwertiger, aromatischer oder aliphatischer Kohlenwasserstoffrest mit einem Diphenylether-, Diphenylthioether-, Benzophenon-, Diphenylmethan-, Diphenylpropan-, Diphenylhexafluorpropan-, Diphenylsulfon-, Biphenyl-, Pyridin- oder Benzolgerüst ist.

11. Hitzebeständige, negativ arbeitende Photoresistzusammensetzung nach Anspruch 8, wobei der Harzbestandteil durch Umsetzung eines aromatischen oder aliphatischen Tetracarbonsäuredianhydrids, das R₁ im Molekül enthält, und eines aromatischen oder aliphatischen Diamins, das R₂ im Molekül enthält,in im wesentlichen äquimolaren Mengen in einem organischen Lösungsmittel erhalten wird.

12. Hitzebeständige, negativ arbeitende Photoresistzusammensetzung nach Anspruch 8, wobei die Verbindung der Formel (II') in einer Menge von 5 - 50 Gewichtsteilen pro 100 Gewichtsteilen des Harzbestandteils verwendet wird.

13. Hitzebeständige, negativ arbeitende Photoresistzusammensetzung nach Anspruch 12, wobei die Menge der Verbindung der Formel (II') 10 - 40 Gewichtsteile pro 100 Gewichtsteilen des Harzbestandteils beträgt.

14. Hitzebeständige, negativ arbeitende Photoresistzusammensetzung nach Anspruch 8, wobei die Verbindung der Formel (II') 2,6-Dimethyl-3,5-dicyano-4-(2'-nitrophenyl)-1,4-dihydropyridin, 2,6-Dimethyl-3,5-diacetyl-4-(2'-nitrophenyl)-1,4-dihydropyridin oder 2,6-Dimethyl-3,5-diacetyl-4-(2',4'-dinitrophenyl)-1,4-dihydropyridin ist.

15. Hitzebeständige, negativ arbeitende Photoresistzusammensetzung nach Anspruch 8, wobei der Auflösungsbeschleuniger 2,6-Dimethyl-3,5-dicyano-4-methyl-1,4-dihydropyridin oder 2,6-Dimethyl-3,5-dicyano-1,4-dihydropyridin ist.

16. Hitzebeständige, negativ arbeitende Photoresistzusammensetzung nach Anspruch 8, wobei der Auflösungsbeschleuniger in einer Menge von 5 - 50 Gewichtsteilen pro 100 Gewichtsteilen des Harzbestandteils verwendet wird.

17. Hitzebeständige, negativ arbeitende Photoresistzusammensetzung nach Anspruch 16, wobei die Menge an Auflösungsbeschleuniger 5 - 15 Gewichtsteile pro 100 Gewichtsteilen des Harzbestandteils beträgt.

18. Lichtempfindliches Substrat, erhältlich durch Beschichten einer Oberfläche eines Substrats mit der hitzebeständigen, negativ arbeitenden Photoresistzusammensetzung nach Anspruch 1 oder 8.

19. Verfahren zur Herstellung eines negativen Musters, umfassend
das Aufbringen einer lichtempfindlichen Flüssigkeit auf ein Substrat, wobei die lichtempfindliche Flüssigkeit durch Auflösen der hitzebeständigen, negativ arbeitenden Zusammensetzung nach Anspruch 1 oder 8 in einem organischen Lösungsmittel hergestellt wird,
Trocknen der erhaltenen Beschichtung, wobei ein Film auf dem Substrat hergestellt wird,
Bestrahlung des erhaltenen Films mit photochemisch wirksamen Strahlen durch eine Photomaske,
Hitzebehandlung des bestrahlten Films, und
Entfernen der unbelichteten Flächen des Films durch Entwicklung mit einer basischen Entwicklungslösung.

20. Verfahren nach Anspruch 19, wobei die Hitzebehandlung bei einer Temperatur von 170 °C oder höher ausgeführt wird.

## Revendications (Revendications pour l'(les) Etat(s) contractant(s) suivant(s): CH, LI, NL)

1. Composition photorésist négative thermorésistante comprenant un composant résine ayant un motif récurrent représenté par la formule (I) : 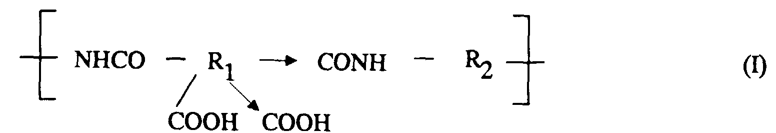 dans laquelle les groupements COOH doivent toujours prendre les positions ortho ou les positions adjacentes par rapport aux liaisons -CONH-, R₁ représente un résidu hydrocarboné tétravalent aromatique ou aliphatique et R₂ représente un résidu hydrocarboné divalent aromatique ou aliphatique ; et
un composé qui devient basique après irradiation par des rayons actiniques, représenté par la formule (II) ou la formule (III): 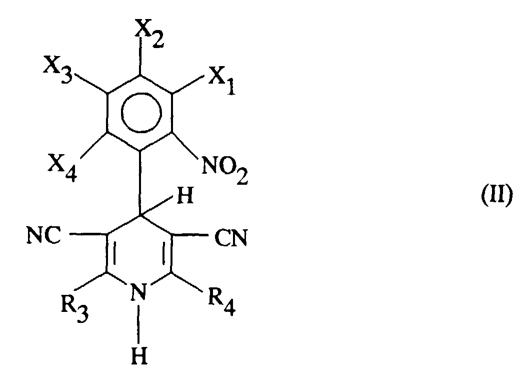 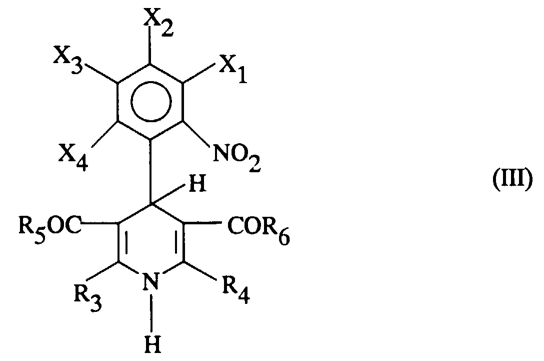 dans lesquelles R₃ et R₄ représentent chacun un atome d'hydrogène ou un groupement alkyle ayant de 1 à 3 atomes de carbone, R₅ et R₆ représentent chacun un groupement alkyle ayant de 1 à 4 atomes de carbone et X₁ à X₄ sont chacun un élément choisi dans le groupe constitué de l'atome d'hydrogène, de l'atome de fluor, du groupement nitro, du groupement méthoxy, des groupements dialkylamino, du groupement amino, du groupement cyano et des groupements fluoroalkyle.

2. Composition photorésist négative thermorésistante selon la revendication 1, dans laquelle le radical R₁ du motif récurrent représenté par la formule (I) est un résidu hydrocarboné tétravalent aromatique ou aliphatique ayant un squelette de benzène, naphtalène, pérylène, biphényle, diphényléther, diphénylsulfone, diphénylpropane, diphénylhexafluoropropane, benzophénone, butane ou cyclobutane.

3. Composition photorésist négative thermorésistante selon la revendication 1, dans laquelle le radical R₂ du motif récurrent représenté par la formule (I) est un résidu hydrocarboné divalent aromatique ou aliphatique ayant un squelette de diphényléther, diphénylthioéther, benzophénone, diphénylméthane, diphénylpropane, diphénylhexafluoropropane, diphénylsulfone, biphényle, pyridine ou benzène.

4. Composition photorésist négative thermorésistante selon la revendication 1, dans laquelle le composant résine est obtenu par réaction d'un dianhydride tétracarboxylique aromatique ou aliphatique contenant R₁ dans sa molécule et une diamine aromatique ou aliphatique contenant R₂ dans sa molécule en des quantités sensiblement équimolaires dans un solvant organique.

5. Composition photorésist négative thermorésistante selon la revendication 1, dans laquelle le composé de formule (II) ou (III) est utilisé en une quantité de 5 à 50 parties en poids pour 100 parties en poids du composant résine.

6. Composition photorésist négative thermorésistante selon la revendication 5, dans laquelle la quantité du composé de formule (II) ou (III) est comprise entre 10 et 40 parties en poids pour 100 parties en poids du composant résine.

7. Composition photorésist négative thermorésistante selon la revendication 1, dans laquelle le composé de formule (III) est la 2,6-diméthyl-3,5-di-acétyl-4-(2',4'-dinitrophényl)-1,4-dihydropyridine.

8. Composition photorésist négative thermorésistante comprenant un composant résine ayant un motif récurrent représenté par la formule (I): 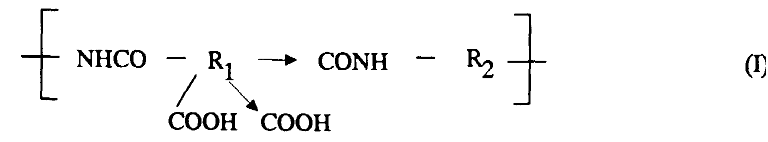 dans laquelle les groupements COOH doivent toujours prendre les positions ortho ou les positions adjacentes par rapport aux liaisons -CONH-, R₁ représente un résidu hydrocarboné tétravalent aromatique ou aliphatique et R₂ représente un résidu hydrocarboné divalent aromatique ou aliphatique ;
un composé qui devient basique après irradiation par des rayons actiniques, représenté par la formule (II') : 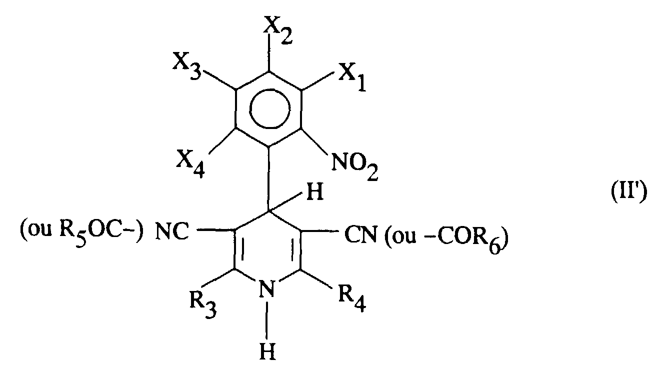 dans laquelle R₃ et R₄ représentent chacun un atome d'hydrogène ou un groupement alkyle ayant de 1 à 3 atomes de carbone, R₅ et R₆ sont chacun un élément choisi dans le groupe constitué des groupements alkyle ayant de 1 à 4 atomes de carbone, des groupements alcoxy ayant de 1 à 4 atomes de carbone, du groupements anilino, du groupement toluidino, du groupement benzyloxy, du groupement amino et des groupements dialkylamino et X₁ à X₄ sont chacun un élément choisi dans le groupe constitué de l'atome d'hydrogène, de l'atome de fluor, du groupement nitro, du groupement méthoxy, des groupements dialkylamino, du groupement amino, du groupement cyano et des groupements fluoroalkyle ; et
un accélérateur de dissolution représenté par la formule (IV) : 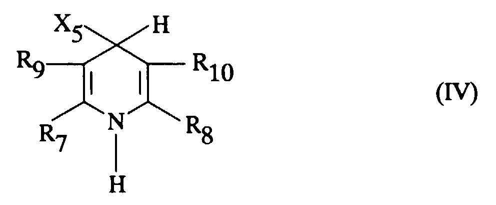 dans laquelle R₇ et R₈ représentent chacun un atome d'hydrogène ou un groupement alkyle ayant de 1 à 3 atomes de carbone, R₉ et R₁₀ sont chacun un élément choisi dans le groupe constitué de l'atome d'hydrogène, du groupement cyano, du groupement acétyle, du groupement amido et des groupements de formule COR₁₁, où R₁₁ est un élément choisi dans le groupe constitué des groupements alkyle ayant de 1 à 5 atomes de carbone, des groupements alcoxy ayant de 1 à 5 atomes de carbone, du groupement anilino, du groupement toluidino et du groupement benzyloxy, et X₅ est un élément choisi dans le groupe constitué de l'atome d'hydrogène, de l'atome de fluor, des groupements alkyle ayant de 1 à 3 atomes de carbone, des groupements fluoroalkyle et du groupement phényle.

9. Composition photorésist négative thermorésistante selon la revendication 8, dans laquelle le radical R₁ du motif récurrent représenté par la formule (I) est un résidu hydrocarboné tétravalent aromatique ou aliphatique ayant un squelette de benzène, naphtalène, pérylène, biphényle, diphényléther, diphénylsulfone, diphénylpropane, diphénylhexafluoropropane, benzophénone, butane ou cyclobutane.

10. Composition photorésist négative thermorésistante selon la revendication 8, dans laquelle le radical R₂ du motif récurrent représenté par la formule (I) est un résidu hydrocarboné divalent aromatique ou aliphatique ayant un squelette de diphényléther, diphénylthioéther, benzophénone, diphénylméthane, diphénylpropane, diphénylhexafluoropropane, diphénylsulfone, biphényle, pyridine ou benzène.

11. Composition photorésist négative thermorésistante selon la revendication 8, dans laquelle le composant résine est obtenu par réaction d'un dianhydride tétracarboxylique aromatique ou aliphatique contenant R₁ dans sa molécule et une diamine aromatique ou aliphatique contenant R₂ dans sa molécule en des quantités sensiblement équimolaires dans un solvant organique.

12. Composition photorésist négative thermorésistante selon la revendication 8, dans laquelle le composé de formule (II') est utilisé en une quantité de 5 à 50 parties en poids pour 100 parties en poids du composant résine.

13. Composition photorésist négative thermorésistante selon la revendication 12, dans laquelle la quantité du composé de formule (II') est comprise entre 10 et 40 parties en poids pour 100 parties en poids du composant résine.

14. Composition photorésist négative thermorésistante selon la revendication 8, dans laquelle le composé de formule (II') est la 2,6-diméthyl-3,5-dicyano-4-(2'-nitrophényl)-1,4-dihydropyridine, la 2,6-diméthyl-3,5-diacétyl-4-(2'-nitrophényl)-1,4-dihydropyridine ou la 2,6-diméthyl-3,5-diacétyl-4-(2',4'-dinitrophényl)-1,4-dihydropyridine.

15. Composition photorésist négative thermorésistante selon la revendication 8, dans laquelle l'accélérateur de dissolution est la 2,6-diméthyl-3,5-dicyano-4-méthyl-1,4-dihydropyridine ou la 2,6-diméthyl-3,5-dicyano-1,4-dihydropyridine.

16. Composition photorésist négative thermorésistante selon la revendication 8, dans laquelle l'accélérateur de dissolution est utilisé en une quantité de 5 à 50 parties en poids pour 100 parties en poids du composant résine.

17. Composition photorésist négative thermorésistante selon la revendication 16, dans laquelle la quantité de l'accélérateur de dissolution est comprise entre 5 et 15 parties en poids pour 100 parties en poids du composant résine.

18. Substrat photosensible obtenu par application sur une surface d'un substrat de la composition photorésist négative thermorésistante selon la revendication 1 ou 8.

19. Procédé de formation d'un motif négatif qui comprend :
l'application d'un liquide photosensible sur un substrat, ledit liquide photosensible étant préparé par dissolution de la composition photorésist négative thermorésistante selon la revendication 1 ou 8 dans un solvant organique,
le séchage du revêtement résultant pour former un film sur le substrat,
l'irradiation du film résultant par des rayons actiniques au travers d'un photomasque,
le traitement thermique du film irradié et
l'élimination des surfaces non exposées du film par développement avec une solution basique de développement.

20. Procédé selon la revendication 19, dans lequel le traitement thermique est réalisé à une température supérieure ou égale à 170°C.

## Revendications (Revendications pour l'(les) Etat(s) contractant(s) suivant(s): BE, DE, FR, GB)

1. Composition photorésist négative thermorésistante comprenant un composant résine ayant un motif récurrent représenté par la formule (I): 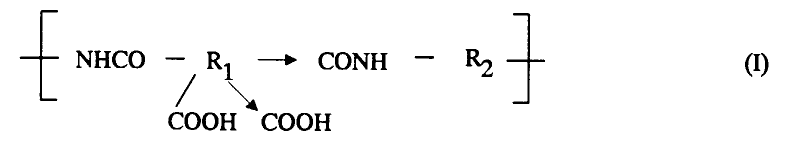 dans laquelle les groupements COOH doivent toujours prendre les positions ortho ou les positions adjacentes par rapport aux liaisons -CONH-, R₁ représente un résidu hydrocarboné tétravalent aromatique ou aliphatique et R₂ représente un résidu hydrocarboné divalent aromatique ou aliphatique ; et
un composé qui devient basique après irradiation par des rayons actiniques, représenté par la formule (II) ou la formule (III) : 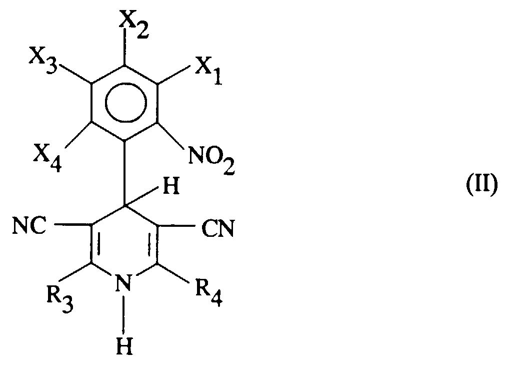 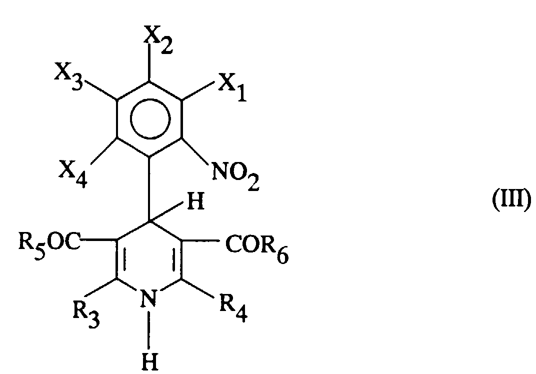 dans lesquelles R₃ et R₄ représentent chacun un atome d'hydrogène ou un groupement alkyle ayant de 1 à 3 atomes de carbone, R₅ et R₆ représentent chacun un groupement alkyle ayant de 1 à 4 atomes de carbone et X₁ à X₄ sont chacun un élément choisi dans le groupe constitué de l'atome d'hydrogène, de l'atome de fluor, du groupement nitro, du groupement méthoxy, des groupements dialkylamino, du groupement amino, du groupement cyano et des groupements fluoroalkyle,
à condition d'exclure la 2,6-diméthyl-3,5-dicyano-4-(2'-nitrophényl)-1,4-dihydropyridine et la 2,6-diméthyl-3,5-diacétyl-4-(2'-nitrophényl)-1,4-dihydropyridine.

2. Composition photorésist négative thermorésistante selon la revendication 1, dans laquelle le radical R₁ du motif récurrent représenté par la formule (I) est un résidu hydrocarboné tétravalent aromatique ou aliphatique ayant un squelette de benzène, naphtalène, pérylène, biphényle, diphényléther, diphénylsulfone, diphénylpropane, diphénylhexafluoropropane, benzophénone, butane ou cyclobutane.

3. Composition photorésist négative thermorésistante selon la revendication 1, dans laquelle le radical R₂ du motif récurrent représenté par la formule (I) est un résidu hydrocarboné divalent aromatique ou aliphatique ayant un squelette de diphényléther, diphénylthioéther, benzophénone, diphénylméthane, diphénylpropane, diphénylhexafluoropropane, diphénylsulfone, biphényle, pyridine ou benzène.

4. Composition photorésist négative thermorésistante selon la revendication 1, dans laquelle le composant résine est obtenu par réaction d'un dianhydride tétracarboxylique aromatique ou aliphatique contenant R₁ dans sa molécule et une diamine aromatique ou aliphatique contenant R₂ dans sa molécule en des quantités sensiblement équimolaires dans un solvant organique.

5. Composition photorésist négative thermorésistante selon la revendication 1, dans laquelle le composé de formule (II) ou (III) est utilisé en une quantité de 5 à 50 parties en poids pour 100 parties en poids du composant résine.

6. Composition photorésist négative thermorésistante selon la revendication 5, dans laquelle la quantité du composé de formule (II) ou (III) est comprise entre 10 et 40 parties en poids pour 100 parties en poids du composant résine.

7. Composition photorésist négative thermorésistante selon la revendication 1, dans laquelle le composé de formule (III) est la 2,6-diméthyl-3,5-diacétyl-4-(2',4'-dinitrophényl)-1,4-dihydropyridine.

8. Composition photorésist négative thermorésistante comprenant un composant résine ayant un motif récurrent représenté par la formule (I): 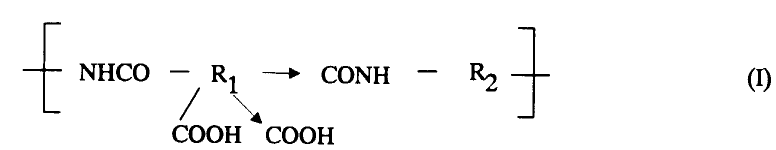 dans laquelle les groupements COOH doivent toujours prendre les positions ortho ou les positions adjacentes par rapport aux liaisons -CONH-, R₁ représente un résidu hydrocarboné tétravalent aromatique ou aliphatique et R₂ représente un résidu hydrocarboné divalent aromatique ou aliphatique ;
un composé qui devient basique après irradiation par des rayons actiniques, représenté par la formule (II') : 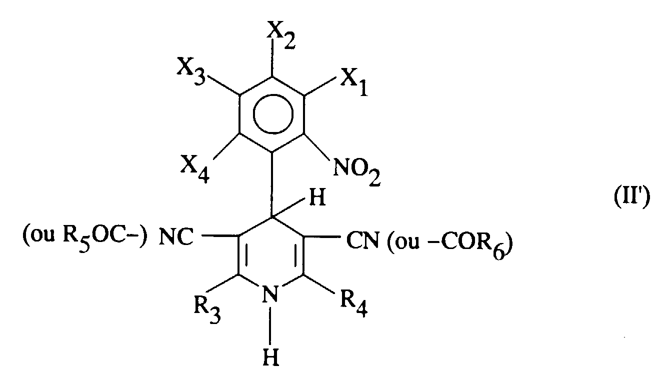 dans laquelle R₃ et R₄ représentent chacun un atome d'hydrogène ou un groupement alkyle ayant de 1 à 3 atomes de carbone, R₅ et R₆ sont chacun un élément choisi dans le groupe constitué des groupements alkyle ayant de 1 à 4 atomes de carbone, des groupements alcoxy ayant de 1 à 4 atomes de carbone, du groupements anilino, du groupement toluidino, du groupement benzyloxy, du groupement amino et des groupements dialkylamino et X₁ à X₄ sont chacun un élément choisi dans le groupe constitué de l'atome d'hydrogène, de l'atome de fluor, du groupement nitro, du groupement méthoxy, des groupements dialkylamino, du groupement amino, du groupement cyano et des groupements fluoroalkyle ; et
un accélérateur de dissolution représenté par la formule (IV) : 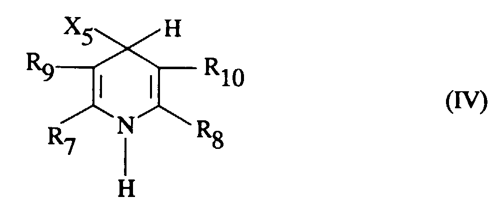 dans laquelle R₇ et R₈ représentent chacun un atome d'hydrogène ou un groupement alkyle ayant de 1 à 3 atomes de carbone, R₉ et R₁₀ sont chacun un élément choisi dans le groupe constitué de l'atome d'hydrogène, du groupement cyano, du groupement acétyle, du groupement amido et des groupements de formule COR₁₁, où R₁₁ est un élément choisi dans le groupe constitué des groupements alkyle ayant de 1 à 5 atomes de carbone, des groupements alcoxy ayant de 1 à 5 atomes de carbone, du groupement anilino, du groupement toluidino et du groupement benzyloxy, et X₅ est un élément choisi dans le groupe constitué de l'atome d'hydrogène, de l'atome de fluor, des groupements alkyle ayant de 1 à 3 atomes de carbone, des groupements fluoroalkyle et du groupement phényle.

9. Composition photorésist négative thermorésistante selon la revendication 8, dans laquelle le radical R₁ du motif récurrent représenté par la formule (I) est un résidu hydrocarboné tétravalent aromatique ou aliphatique ayant un squelette de benzène, naphtalène, pérylène, biphényle, diphényléther, diphénylsulfone, diphénylpropane, diphénylhexafluoropropane, benzophénone, butane ou cyclobutane.

10. Composition photorésist négative thermorésistante selon la revendication 8, dans laquelle le radical R₂ du motif récurrent représenté par la formule (I) est un résidu hydrocarboné divalent aromatique ou aliphatique ayant un squelette de diphényléther, diphénylthioéther, benzophénone, diphénylméthane, diphénylpropane, diphénylhexafluoropropane, diphénylsulfone, biphényle, pyridine ou benzène.

11. Composition photorésist négative thermorésistante selon la revendication 8, dans laquelle le composant résine est obtenu par réaction d'un dianhydride tétracarboxylique aromatique ou aliphatique contenant R₁ dans sa molécule et une diamine aromatique ou aliphatique contenant R₂ dans sa molécule en des quantités sensiblement équimolaires dans un solvant organique.

12. Composition photorésist négative thermorésistante selon la revendication 8, dans laquelle le composé de formule (II') est utilisé en une quantité de 5 à 50 parties en poids pour 100 parties en poids du composant résine.

13. Composition photorésist négative thermorésistante selon la revendication 12, dans laquelle la quantité du composé de formule (II') est comprise entre 10 et 40 parties en poids pour 100 parties en poids du composant résine.

14. Composition photorésist négative thermorésistante selon la revendication 8, dans laquelle le composé de formule (II') est la 2,6-diméthyl-3,5-dicyano-4-(2'-nitrophényl)-1,4-dihydropyridine la 2,6-diméthyl-3,5-di-acétyl-4-(2'-nitrophényl)-1,4-dihydropyridine ou la 2,6-diméthyl-3,5-di-acétyl-4-(2',4'-dinitrophényl)-1,4-dihydropyridine.

15. Composition photorésist négative thermorésistante selon la revendication 8, dans laquelle l'accélérateur de dissolution est la 2,6-diméthyl-3,5-dicyano-4-méthyl-1,4-dihydropyridine ou la 2,6-diméthyl-3,5-dicyano-1,4-dihydropyridine.

16. Composition photorésist négative thermorésistante selon la revendication 8, dans laquelle l'accélérateur de dissolution est utilisé en une quantité de 5 à 50 parties en poids pour 100 parties en poids du composant résine.

17. Composition photorésist négative thermorésistante selon la revendication 16, dans laquelle la quantité de l'accélérateur de dissolution est comprise entre 5 et 15 parties en poids pour 100 parties en poids du composant résine.

18. Substrat photosensible obtenu par application sur une surface d'un substrat de la composition photorésist négative thermorésistante selon la revendication 1 ou 8.

19. Procédé de formation d'un motif négatif qui comprend :
l'application d'un liquide photosensible sur un substrat, ledit liquide photosensible étant préparé par dissolution de la composition photorésist négative thermorésistante selon la revendication 1 ou 8 dans un solvant organique,
le séchage du revêtement résultant pour former un film sur le substrat,
l'irradiation du film résultant par des rayons actiniques au travers d'un photomasque,
le traitement thermique du film irradié et
l'élimination des surfaces non exposées du film par développement avec une solution basique de développement.

20. Procédé selon la revendication 19, dans lequel le traitement thermique est réalisé à une température supérieure ou égale à 170°C.
